# EUROPÄISCHE PATENTSCHRIFT

(11) **EP 2 087 490 B1**
(45) Veröffentlichungstag und Bekanntmachung des Hinweises auf die Patenterteilung: **13.12.2017**
(21) Anmeldenummer: 07818947.9
(22) Anmeldetag: 12.10.2007
(51) Int. Cl.: H01B 1/22, H05K 1/09, C09D 11/00, C09D 5/24, B05D 5/06, C09D 11/30, H05K 3/12

(54) **SILBERHALTIGE WÄSSRIGE FORMULIERUNG UND IHRE VERWENDUNG ZUR HERSTELLUNG VON ELEKTRISCH LEITENDEN ODER SPIEGELNDEN BESCHICHTUNGEN**
AQUEOUS FORMULATION CONTAINING SILVER, AND ITS USE FOR PRODUCTION OF ELECTRICALLY CONDUCTIVE OR REFLECTIVE COATINGS
FORMULATION AQUEUSE CONTENANT DE L'ARGENT ET SON UTILISATION POUR LA PRÉPARATION DE REVÊTEMENTS ÉLECTRIQUEMENT CONDUCTEURS OU RÉFLÉCHISSANTS

(30) Priorität: 25.10.2006 DE 102006050380; 06.08.2007 DE 102007037079
(43) Veröffentlichungstag der Anmeldung: 12.08.2009
(73) Patentinhaber: Clariant International Ltd, 4132 Muttenz (CH)
(72) Erfinder: BOLL, Matthias, 51061 Köln (DE); EIDEN, Stefanie, 51371 Leverkusen (DE); KIJLSTRA, Johan, 51519 Odenthal (DE)
(74) Vertreter: Jacobi, Carola
(86) Internationale Anmeldenummer: PCT/EP2007/008876
(87) Internationale Veröffentlichungsnummer: WO 2008/049519

(56) Entgegenhaltungen:
- EP-A- 1 712 635
- WO-A-99/45077
- WO-A-03/032084
- WO-A-03/038002
- WO-A-03/045584
- WO-A-2006/066033
- US-A1- 2004 178 391

## Beschreibung

Die Erfindung geht aus von feinteiligen Metallpartikeln und Metallsuspensionen für die Herstellung elektrisch leitender Schichten.

Kunststoffbauteile besitzen in der Regel zwar gute mechanische und teilweise zusätzlich gute optische Eigenschaften (wie etwa die Transparenz bei Polycarbonat), die meisten technischen Kunststoffe sind aber elektrische Isolatoren.

Die Verknüpfung von mechanischen Eigenschaften wie Stabilität, optischen Eigenschaften wie Transparenz und elektrischen Eigenschaften wie elektrischer Leitfähigkeit bei transparenten Kunststoffen kann für eine ganze Reihe von Anwendungen enorme Vorteile bringen. Hervorzuheben ist hierbei die Transparenz von Bauteilen, die in vielen Anwendungsbereichen möglichst hoch sein soll, zum Beispiel für Scheiben im Automobilbau oder an Gebäuden, oder für Sichtfenster in Geräten, die mit erweiterten elektrischen Anwendungen gekoppelt werden sollen (elektrische Beheizung, Abschirmung elektromagnetischer Strahlung, Ableitung von Oberflächenladung). Gleichzeitig soll in den meisten Fällen die mechanische Stabilität des Grundwerkstoffes wie auch die Designfreiheit hinsichtlich der Formgebung möglichst hoch sein. Weil die Linienbreite sehr gering gewählt werden kann, ist auch der Einsatz im Bereich der Solarzellentechnik (Photovoltaikanlagen) als hochleitfähiger elektrischer Leiter gut vorstellbar. Vorteile ergeben sich hierbei aus der niedrigen Flächenbelegung durch den elektrischen Leiter auf der der Lichtquelle zugewandten Seite.

Durch die Verwendung von mit Metallpartikeln im Nanometerbereich gefüllten Tinten lassen sich zum Beispiel mit Hilfe der InkJet-Technologie schmale, elektrisch leitfähige Bahnen mit praktisch beliebigen Geometrien zum Beispiel auf Kunststofffolien drucken. Besonders wünschenswert ist hierbei, dass die Linienbreite solcher Leiterbahnen etwa 20µm erreicht beziehungsweise auch unterschreitet. Ab dieser Grenze sind Strukturen für das menschliche Auge in der Regel nur noch schwer zu erkennen und ein störender optischer Effekt an transparenten Bauteilen entfällt.

Eine weitere Möglichkeit Leiterbahnen mit der oben beschriebenen Feinheit, d.h. die visuell schwer oder gar nicht auf Oberflächen erkennbar sind (Strukturen mit einer Linienbreite <20µm), insbesondere auf polymeren Substraten, zu erzeugen, besteht, indem das Substrat in einem Vorbehandlungsschritt mit der notwendigen Strukturierung versehen wird, um die entstandene Strukturierung nachfolgend mit dem leitenden Material zu füllen.

Es müssen aber wenn möglich noch folgende, weitere Anforderungen erfüllt werden, die mit den bisher bekannten Tinten nicht alle zugänglich wurden.

Die elektrischen Leiterbahnen müssen sowohl temperaturbeständig (d.h. kurzzeitig bis 400°C) als auch mechanisch flexibel sein, die zu ihrer Herstellung verwendeten Metallpartikel-Tinten sollten die Herstellung von Bahnen einer Liniendicke von 100 µm und darunter (bis zu 20 µm) ermöglichen, sowie günstiger und leichter zu verarbeiten sein als bekannte Leitpasten. Damit ergibt sich die Forderung nach einer deutlich niedrigeren Viskosität, wenn Ink-jet Verfahren verwendet werden sollen, einem geeigneten Benetzungs- und Spreitungsvermögen und kleineren Partikeln als dies herkömmliche Leitpasten aufweisen. Insbesondere das Benetzungsverhalten und Spreitungsvermögen muss für die vorgestellte Möglichkeit der Füllung der Vertiefungen von vorstrukturierten Oberflächen beachtet werden. Für eine solche spezielle Anwendung sollte die Tinte neben den oben angegebenen Eigenschaften auch einen niedrigen Kontaktwinkel (<45°) auf dem gewählten Substrat und/oder eine möglichst hohe Oberflächenspannung (> 10mN/m) besitzen.

Insbesondere sollte auch eine spezifische elektrische Leitfähigkeit der gedruckten, getrockneten und wärmebehandelten Tinte deutlich besser als 10² Ω⁻¹• cm⁻¹ erreicht werden. Die Wärmebehandlung sollte insbesondere bei höchstens 140°C durchgeführt werden, dem Erweichungspunkt von z. B. Polycarbonat. Außerdem sollten die entstandenen Leiterbahnen möglichst mechanisch flexibel sein, so dass sie auch bei einer Dehnung des Materials die Leitfähigkeit beibehalten. Insbesondere sollten die Leiterbahnen auch eine besonders gute Haftung auf den gängigen Substraten, speziell auf Polycarbonat, haben.

Eine ganz besondere Anforderung an eine solche Tinte besteht darin, dass die Partikelgröße der Metallpartikel deutlich kleiner als 20 µm sein sollte und dass die Tinte über eine niedrige Viskosität (kleiner als 150 mPa•s) verfügt. Es erscheint ebenfalls vorteilhaft, wenn die verwendeten Partikel in der Formulierung geeignet sind dichte Packungen nach dem Druckvorgang zu bilden, die bereits bei geringer Konzentration und niedriger Verarbeitungstemperatur zur gewünschten Leitfähigkeit der gedruckten Struktur führen.

Eine weitere besondere alternative Aufgabe besteht darin, für den Werkstoff Polycarbonat eine geeignete Möglichkeit zu finden, spiegelnde Oberflächen auf dreidimensionalen Strukturen des Polycarbonats möglichst einfach zu erzeugen. Ein bisher gängiges Verfahren hierzu ist zum Beispiel die Bedampfung (physical vapor deposition, "PVD") mit Aluminium oder anderen, unter diesen Bedingungen verdampfbaren oder zerstäubungsfähigen Metallen, die allerdings Nachteile bei der Verspiegelung von dreidimensionalen Strukturen (ungleichmäßige Belegung der zu bedampfenden Matrix) hat sowie einen vergleichsweise hohen apparativen Aufwand (Arbeiten unter vermindertem Druck, Anwendung von Vakuumtechnik und Druckschleuse) erfordert. Des weiteren haben die PVD- und Zerstäubungsverfahren Nachteile betreffend die Haftfestigkeit der aufgedampften Schicht auf dem Substrat. So lassen sich die erzeugten Metallschichten ohne eine weitere vorhergehende Schutzlackierung nicht direkt berühren, ohne dass die Schichten daraufhin zerstört sind.

R. W. Vest (Metallo-organic materials for Improved Thick Film Reliability, Nov. 1, 1980, Final Report, Contract N00163-79-C-0352, National Avionic Center) beschreibt eine druckbare Formulierung für Leiterbahnen, doch liegt hier die erforderliche Temperatur, um eine Leitfähigkeit zu erzeugen, bei 250 °C. d. h. weit über der für viele technische Kunststoffe möglichen Anwendungstemperatur.

Die US Patente US-A-5,882,722 und US-A-6,036,889 beschreiben eine leitfähige Formulierung, die metallische Partikel, einen Precursor und ein organisches Lösungsmittel enthält und die erst bei einer Temperatur ab 200 °C leitfähige Strukturen bildet. Auch ist hier die Viskosität der Formulierung so hoch, dass diese Formulierung grundsätzlich nicht in einem Ink-Jet Drucker verarbeitet werden kann.

Formulierungen auf Basis von leicht zersetzlichen Silberverbindungen als niedrigviskose Lösungen mit niedriger Sintertemperatur sind Inhalt der Offenlegung WO 03/032084 (A2). Hier wird auch von niedrigen Zersetzungstemperaturen berichtet, die allerdings nicht mit spezifischen Leitfähigkeiten der erhaltenen Strukturen hinterlegt sind. Die niedrigste Temperatur, bei der mit einer Silberformulierung eine leitfähige Beschichtung erreicht wird, wird mit 185° C angegeben.

Die Schriften WO-2003/038002A2 und US-A-2005/0078158 beschreiben Formulierungen mit Silbernanopartikeln, die unter anderem mit Natrium-Cellulosemethylcarbonsäure stabilisiert werden. In diesen Schriften wird zwar die Notwendigkeit der Nachbehandlung z.B. durch Wärme, oder Flockungsmittel beschrieben, jedoch weder Verarbeitungstemperaturen noch die Leitfähigkeit der aus der Formulierung erhaltenen Mikrostrukturen beschrieben. Weiterhin wird die genaue Verteilung der verwendeten und erhaltenen Nanopartikel nicht offenbart, wenngleich der Bereich der Größe kleiner 100 nm betragen soll. Der Gehalt der offenbarten Formulierungen beträgt nicht mehr als 1,2 Gew-%. Es wird allerdings dargestellt, dass Anteile von 60-74 Gew-% denkbar wären. Es wird ebenfalls beschrieben, dass diese durch die starke Viskositätserhöhung der resultierenden Formulierung für Tintenstrahldruck nicht geeignet sind. Eine obere Grenze des Gehaltes, nach dem hier eine Verwendung noch möglich wäre, wird nicht offenbart.

In WO 2006/072959A2 wird eine Methode offenbart, mittels derer man Metall-Nanopartikel erhalten kann, die z.B. für den l'intenstrahldruck verwendbar waren. Hierbei werden Nanopartikel mit Größen kleiner 20 nm und unbekannter Größenverteilung erhalten. Eine bimodale Verteilung wird nicht offenbart. Der verwendbare Gehalt von resultierenden Formulierungen liegt im Bereich von 0,5-80 Gew-%. Weiterhin wird offenbart, dass im Herstellungsprozess eine Vorreduktion von Silberacetat mittels wasserlöslicher Polymere notwendig ist, um unter anderem die Agglomeration der erhaltenen Nanopartikel zu verhindern. Es liegt also nahe, dass auch in der resultierenden Formulierung die zur Vorreduktion verwendeten Polymere noch mit den Partikeln interagieren / an diese gebunden sind, damit der oben dargestellte Effekt beibehalten werden kann. Insgesamt wird ein aufwändiger Prozess bis zu einer Tintenformulierung, beinhaltend Vorreduktion, Hauptreduktion, Einengen und Endformulierung, offenbart, der eine großtechnische, kosteneffiziente Anwendbarkeit nicht vermuten lässt.

Auch in WO 2006/066033 wird eine Ink-jet Tinte umfassend ein Silbersalz in Kombination mit einem Amin als Sensibilisator für das Silbersalz beschrieben, wobei beim Drucken der Tinte zumindest ein Teil des Silbersalzes reduziert wird. US 2004/178391 beschreibt druckbare Tinten enthaltend z. B. eine zersetzbare metallorganische Verbindung und ein Additiv zur Verringerung der Aushärtungstemperatur, wobei die Tinte nach Druck bei einer Temperatur von unter 200 °C ausgehärtet werden kann. Als Additiv zur Verringerung der Aushärtungstemperatur kommen bevorzugt halogengruppenhaltige Polymere in Frage.

Ein anderer Weg zur Darstellung kolloidaler Metall-Nanopartikel wird in US-2004/0147618 offenbart. Es wird eine monomodale Verteilung metallischer Nanopartikel in Größen zwischen 2 und 10 nm erhalten, indem ein Metallsalz mit einem wasserlöslichen Polymer in einem Lösungsmittel gelöst wird und unter Schutzgas (z.B. Stickstoff oder Argon) mit Strahlung behandelt wird. Eine Verwendung der erhaltenen Dispersion als Tinte wird erwähnt, Es wird allerdings keine Formulierung für eine solche Tinte offenbart. Insbesondere wird der praktisch verwendbare Gehalt der Metallpartikel in einer Tintenformulierung nicht dargestellt. Außerdem ist auch hier die Herstellung der Tinte durch das Arbeiten unter Schutzgas für einen großtechnischen Prozess sehr aufwendig.

Um eine niedrige Sintertemperatur zu erreichen, wird in der WO 2005/0136638 eine Mischung aus Silber- und Gold-Nanopartikeln benutzt. Von einer guten Leitfähigkeit wird hier ab einer Sintertemperatur von 200°C gesprochen.

In der Offenlegung EP 1 493 780 A1 wird eine Silberpaste beschrieben, die nach Temperaturbehandlung bei 150 °C sehr gut leitend ist, allerdings ist diese Formulierung zu hochviskos, um sie mittels Ink-jet drucken zu können.

Die Firma Cabot bietet das Produkt "Cabot Inkjet Silver Conductor AG-IJ-G-100-S1" an, das eine Silberleittinte ist, die per Inkjet-Technologie angewendet werden kann. Tests zur Haftung auf Kunststoffen wie Polycarbonat werden in den vorliegenden Schriften nicht erwähnt.

Die Firma HARIMA bietet die Produktlinie "NP Series Nano-Paste" an, bei dem es sich um eine Silberleittinte auf Nanopartikelbasis mit niedriger Viskosität handelt. HARIMA gibt allerdings Sintertemperaturen von 210-230°C an. Die Verarbeitungstemperatur macht die Paste zur Bedruckung von Polymeren ungeeignet.

Die vorgenannten Aufgaben können mit Hilfe der nachstehend beschriebenen silberhaltigen Formulierung gelöst werden. Insbesondere können Gegenstände aus Polycarbonat zum Beispiel durch Tauchlackierung oder Guss und anschließende Wärmebehandlung besonders einfach und kostengünstig gleichmäßig mit einer dünnen glänzenden Schicht Silber besonders haftfest überzogen werden. Weiterhin ist es möglich mit einer erfindungsgemäßen Formulierung auf vorstrukturierten Oberflächen durch Füllung der Strukturierung visuell schwer oder nicht erkennbare Leiterbahnen (Breite < 20µm, z.B. auf Polycarbonat) zu erzeugen.

Aus wirtschaftlicher Sicht sind hierbei möglichst geringe Silberkonzentrationen im verwendeten Lack und niedrige Schichtdicken vorzuziehen, da bereits eine sehr dünne Silberschicht ausreicht, eine durchgehend reflektierende Schicht zu erzeugen und Silber ein teures Edukt für eine solche Formulierung darstellt.

Die vorstehende besondere Aufgabe der Bedruckung von Kunststoffen wird z. B. mit Hilfe einer silberhaltigen Formulierung gelöst, die mit einem Drucker, beispielsweise einem Piezo-Ink-Jet Drucker auf ein Substrat, beispielsweise Polycarbonat, aufgebracht werden kann, und die nach oder während des Auftragens (oder sowohl als auch) erwärmt wird, damit sich eine Schicht mit gewünschter elektrischer Leitfähigkeit ausbilden kann. Vorzugsweise bildet diese Formulierung schon bei niedrigen Nachbehandlungstemperaturen (<= 140°C) eine elektrische Leitfähigkeit aus, so dass die Herstellung von elektronischen Strukturen z. B. auf Werkstoffen wie Polycarbonat möglich wird.

Die Lösung der Aufgabenstellung zur Erzeugung visuell schwer oder nicht erkennbarer Leiterbahnen kann auch analog mit gezielter Einbringung in die Bahnen bzw. Vertiefungen vorstrukturierter Oberflächen erfolgen.

Gegenstand der Erfindung ist eine silberhaltige, disperse, Wasser enthaltende Formulierung wenigstens umfassend
a) von 0,5 bis 30 Gew.-Teile Silbermetallpartikel mit einem effektiven Durchmesser von höchstens 150 nm, bevorzugt von höchstens 100 nm, besonders bevorzugt von 40 bis 80 nm, mit einer bimodalen Größenverteilung der Silbernanopartikel, ermittelt mit der Laserkorrelationsspektrakopie,
b) von 50 bis 99,5 Gew.-Teile Wasser und gegebenenfalls Lösungsmittel bis zu 30 Gew.-Teile,
c) von 0,01 bis 10 Gew. -Teile wenigstens eines, insbesondere polymeren Dispergierhilfsmittels,
d) von 0 bis 5 Gew.- Teile Filmbildner und gegebenenfalls
e) von 0 bis 5 Gew.- Teile Additive,
f) von 0 bis 5 Gew.-Teile leitfähige Polymere,
dadurch gekennzeichnet, dass die Formulierung eine Viskosität von höchstens 150 mPa•s aufweist.

Im Fall der Aufbringung auf vorstrukturierte Substrate zeichnet sich die Formulierung weiterhin dadurch aus, dass sie mit dem Substrat einen geringen Kontaktwinkel (d.h. < 45° auf Polycarbonat) bildet und eine möglichst hohe Oberflächenspannung (>10mN/m) besitzt. Bevorzugt liegt hier der Kontaktwinkel unter 30° und/oder die Oberflächenspannung der Formulierung über 20mN/m. Besonders bevorzugt liegt hier der Kontaktwinkel unter 10° und / oder die Oberflächenspannung der Formulierung über 40 mN/m. Der Kontaktwinkel wird auf Polycarbonat bei 25°C und unter Normalbedingungen gemessen.

Die Summe der Gewichtsteile der Komponenten der Formulierung beträgt insbesondere 100 Gewichtsteile.

Die Größenbestimmung mittels Laserkorrelationsspektroskopie ist literaturbekannt und z. B. beschrieben in T. Allen, Particle Size Measurements, Bd. 1., Kluver Academic Publishers, 1999.

Bevorzugt umfasst das Dispergierhilfsmittel wenigstens ein Mittel ausgewählt aus der Gruppe: Alkoxylate, Alkylolamide, Ester, Aminoxide, Alkylpolyglukoside, Alkylphenole, Arylalkylphenole, wasserlösliche Homopolymere, wasserlösliche statistische Copolymere, wasserlösliche Blockcopolymere, wasserlösliche Pfropfpolymere, insbesondere Polyvinylalkohole, Copolymere aus Polyvinylalkoholen und Polyvinylacetaten, Polyvinylpyrrolidone, Cellulose, Stärke, Gelatine, Gelatinederivate, Aminosäurepolymere, Polylysin, Polyasparaginsäure, Polyacrylate, Polyethylensulfonate, Polystyrolsulfonate, Polymethacrylate, Kondensationsprodukte von aromatischen Sulfonsäuren mit Formaldehyd, Naphthalinsulfonate, Ligninsulfonate, Copolymerisate acrylischer Monomere, Polyethylenimine, Polyvinylamine, Polyallylamine, Poly(2-vinylpyridine), Block-Copolyether, Block-Copolyether mit Polystyrolblöcken und/oder Polydiallyldimethylammoniumchlorid ist.

Das Dispergierhilfsmittel ist besonders bevorzugt ausgewählt aus der Reihe: Polyvinylpyrrolidon, Blockcopolyether und Blockcopolyether mit Polystyrolblöcken. Ganz besonders bevorzugt werden Polyvinylpyrrolidon mit Molmasse von etwa 10000 amu (z. B. PVP K15 der Firma Fluka) und Polyvinylpyrrolidon mit Molmasse von etwa 360000 amu (z. B. PVP K90 der Firma Fluka) und besonders bevorzugt Block-Copolyether mit Polystyrolblöcken, mit 62 Gew.-% C₂-Polyether, 23 Gew.-% C₃-Polyether und 15 Gew.-% Polystyrol, bezogen auf das getrocknete Dispergierhilfsmittel, mit einem Verhältnis der Blocklängen C₂-Polyether zu C₃-Polyether von 7:2 Einheiten (z. B. Disperbyk 190 der Firma BYK-Chemie, Wesel) eingesetzt.

Besonders bevorzugt wird ein Lösungsmittel b) ausgewählt aus der Reihe: C₁- bis C₅- Alkohol, insbesondere C₁- bis C₃- Alkohol, Ether, insbesondere Dioxalan, Ketone, insbesondere Aceton, verwendet.

Der Filmbildner d) ist bevorzugt ausgewählt aus der Reihe: Polydimethylsiloxan, Polyacrylat, Ammoniumsalze von Polyacrylaten, Siloxane, Wachskombinationen, Copolymere mit pigmentaktiven Gruppen, niedermolekulare Polymere, Hydroxyethylcellulose, Polyvinylalkohol oder aus der Gruppe der weiter oben genannten Dispergierhilfsmittel, hier besonders bevorzugt z. B. das Dispergierhilfsmittel BYK 356 der Firma BYK-Chemie, Wesel), ein Polyacrylat sowie das BYK 154 derselben Firma, das Ammoniumsalz eines Acrylatcopolymeren.

Das Additiv e) ist bevorzugt ausgewählt aus der Reihe: Pigmente, Entschäumer, Lichtschutzmittel, optische Aufheller, Korrosionsinhibitor, Antioxidantien, Algizide, Weichmacher, Verdicker, oberflächenaktive Substanzen. Ganz besonders bevorzugt wird Pluronic PE10400 (der Firma BASF, Ludwigshafen), ein triblock-Copolymer aus C₃ -Polyether, C₂-Polyether, C₃-Polyethereinheiten mit 40 Gew.-% C₂-Polyether als Additiv eingesetzt.

Das leitfähige Polymer f) ist bevorzugt gewählt aus der Reihe: Polypyrrol, Polyanilin, Polythiophen, Polyphenylenvinylen, Polyparaphenylen, Polyethylendioxythiophen, Polyfluoren, Polyacetylen, besonders bevorzugt Polyethylendioxythiophen in Kombination mit Polystyrolsulfonsäure.

Die Silberpartikel a) weisen einen effektiven Partikeldurchmesser von 10 bis 150 nm auf, bevorzugt von 40 bis 80 mn, ermittelt mit der Laserkorrelationsspektrokopie.

Die Silberpartikel a) sind bevorzugt in der Formulierung zu einem Anteil von 1 bis 20 Gew.-Teilen, besonders bevorzugt 2 bis 6 Gew.-Teilen enthalten.

Der Gehalt an Dispergierhilfsmittel c) beträgt bevorzugt 0,02 bis 5 Gew.-Teile, besonders bevorzugt 0,04 bis 2 Gew.- Teile.

Eine besonders vorteilhafte Formulierung wird dadurch erhalten, dass das Silbersol einer Membranfiltration mit einer Filterfeinheit von höchstens 100.000 Da zur Reinigung und Aufkonzentration unterzogen wurde.

Weiterer Gegenstand der Erfindung ist die Verwendung der erfindungsgemäßen Formulierung zur Erzeugung von elektrisch leitenden und/oder optisch spiegelnden Beschichtungen, insbesondere von Leiterbahnen einer Linienbreite von kleiner als 100 µm, bevorzugt kleiner als 80 µm.

Gegenstand der Erfindung ist auch ein Verfahren zur Erzeugung von Leiterbahnen einer Linienbreite von kleiner als 100 µm, bevorzugt kleiner als 80 µm, das dadurch gekennzeichnet ist, dass die neue Formulierung mit Hilfe der Tintenstrahltechnik auf eine Substratoberfläche gedruckt und insbesondere bei einer Temperatur von höchstens 140 °C zur Entfernung von Wasserresten und gegebenenfalls Lösungsmitteln sowie gegebenenfalls zur Sinterung vorhandener Silberpartikel wärmebehandelt wird.

Daneben ist es ein weiterer Gegenstand dieser Erfindung ein Verfahren zur Erzeugung von Leiterbahnen mit einer Linienbreite von kleiner 20 µm, in dem die neue Formulierung in die vorgegebene Strukturierung des Substrates eingebracht wird, wobei die Strukturierung eine Linienbreite von < 20 µm aufweist, und die aufgebrachte Formulierung insbesondere bei einer Temperatur von höchstens 140°C zur Entfernung von Wasser und gegebenenfalls Lösungsmittel wärmebehandelt wird.

Erfindungsgegenstand ist auch noch ein Substrat, insbesondere ein transparentes Kunststoffsubstrat aufweisend eine elektrisch leitende und/oder optisch spiegelnde Beschichtung, die aus einer erfindungsgemäßen Formulierung erhältlich ist.

Besonders bevorzugt ist ein Substrat, das dadurch gekennzeichnet ist, dass die elektrisch leitende Beschichtung Leiterbahnen einer Linienbreite von kleiner als 100 µm, bevorzugt kleiner als 80 µm umfasst, wobei die Leitfähigkeit in den Leiterbahnen mindestens 7•10⁶ S/m beträgt.

Die neue Formulierung weist wie oben beschrieben Silberpartikel mit einer bimodalen Größenverteilung auf. Es wurde überraschend gefunden, dass die bimodale Verteilung vorteilhaft für eine Ausbildung leitfähiger Strukturen bereits bei niedrigerem Gehalt der Silbernanopartikel ist. Man kann annehmen, dass dies bedingt wird durch die Füllung der entstehenden Zwickelvolumina zwischen den größeren Partikeln durch Kleinere. Hierdurch entstehen bei der thermischen Nachbehandlung der Tinte größere, durchgängige Kontaktflächen. Somit erreicht die resultierende Formulierung bei niedrigerem Massegehalt die gleiche Leitfähigkeit einer Tinte mit annähernd monodisperser Verteilung bei annähernd gleichem effektiven Durchmesser, oder eine höhere bei gleichem Massegehalt und gleichem effektivem Durchmesser.

Erfüllt werden die oben beschriebenen Anforderungen weiterhin durch eine Formulierung, die Silbernanopartikel, Lösungsmittel, Filmbildner, Dispergierhilfsmittel und eventuell andere Additive enthält. Vorzugsweise enthält sie kleine Silbernanopartikel die - im wesentlichen - einen effektiven Durchmesser von 75 nm mit einer bimodalen Verteilung in einer niedrigen Konzentration von 0,5 bis 20 Gew.-%, bevorzugt von 2 bis 5 Gew.-% enthalten, wodurch nur eine geringe Menge an Dispergierhilfmitteln notwendig ist. Vermutlich auch hierdurch genügt eine niedrige Nachbehandlungstemperatur von 140 °C, um hohe Leitfähigkeiten zu erzielen. Die Formulierung kann zum Beispiel durch Ink-Jet-Drucktechnik, Tauch-, Flut- oder Gussverfahren auf Polycarbonat aufgebracht werden, anschließend getrocknet und bei 140°C mehrere Stunden getempert werden. Man erhält dann sehr gut haftende, elektronisch leitfähige Strukturen beziehungsweise, bei einem flächigen Auftrag, optisch reflektierende Schichten, beide mit hohem Haftvermögen auf Polycarbonat.

Die in der Formulierung bevorzugt verwendeten Silbersole werden aus Ag₂O durch Reduktion mit einem Reduktionsmittel wie wässriger Formaldehydlösung (FA) nach vorhergehender Zugabe eines Dispergierhilfsmittels hergestellt. Dazu werden die Ag₂O-Sole zum Beispiel durch schnelles Vermischen von Silbernitratlösung mit NaOH durch schnelles Rühren batchweise oder durch Verwendung eines Mikromischers entsprechend der noch unveröffentlichten deutschen Patentanmeldung mit dem Aktenzeichen 10 2006 017 696 in einem kontinuierlichen Prozess hergestellt. Der Inhalt der Patentanmeldung mit dem Aktenzeichen 10 2006 017 696 gehört zum Offenbarungsgehalt der vorliegenden Patentanmeldung. Anschließend werden die Ag₂O-Nanopartikel mit FA im Überschuss in einem Batch-Verfahren reduziert und abschließend durch Zentrifugation oder Membranfiltration, bevorzugt durch Membranfiltration, gereinigt. Besonderes vorteilhaft ist diese Produktionsweise, weil die Menge an auf der Oberfläche der Silbernanopartikel gebundenen organischen Hilfsmitteln hierbei gering gehalten werden kann und weiterhin eine bimodale Größenverteilung erhalten werden kann. Insbesondere werden hierdurch keine Vorbehandlungsschritte, z.B. eine Vorreduktion in Gegenwart von Polymeren, oder weitere Nachbehandlungsschritte außer Energieeintrag, z.B. Aktivierung eines Precursor-Systems, oder Flokulation benötigt.

Weiterhin wurde überraschenderweise gefunden, dass der Dispergierhilfsmittelgehalt c) der Silberdispersion nach der Diafiltration bzw. Zentrifugation einen entscheidenden Einfluss auf die Leitfähigkeit der erzeugten Strukturen ausübt.

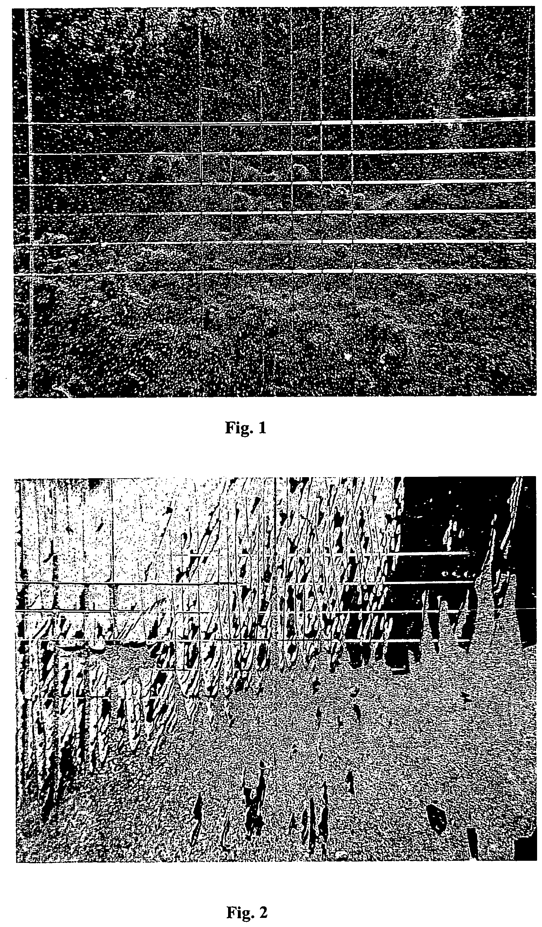

Die Erfindung wird nachstehend unter Verwendung der Figuren beispielhaft näher erläutert. Figur 1 zeigt die Mikrofotographie einer erfindungsgemäßen Beschichtung von Polycarbonat nach einem Kratztest. Figur 2 zeigt die Mikrofotographie einer Beschichtung gemäß dem Stand der Technik nach einem Kratztest.

### Beispiele

### Beispiel 1

### Herstellung der Silberpartikel mit Aufreinigung durch Zentrifugation

Es wurden eine 0,054 molare Silbemitratlösung mit einer Mischung aus einer 0,054 molaren Natronlauge und dem Dispergierhilfsmittel Disperbyk 190 (Hersteller BYK Chemie) (1 g/l) in einem Volumenverhältnis von 1:1 versetzt und 10 min gerührt. Ein braun gefärbtes Ag₂O-Nanosol entstand. Zu dieser Reaktionsmischung wurde unter Rühren eine wässrige 4,6 molare Formaldehyd-Lösung zugesetzt, so dass das molare Verhältnis Ag⁺ zu Reduktionsmittel 1:10 betrug. Diese Mischung wurde auf 60°C erwärmt, 30 min bei dieser Temperatur gehalten und anschließend abgekühlt. Die Partikel wurden mittels Zentrifugation (60 min bei 30000 U/min) aufgereinigt und durch Eintrag von Ultraschall (1 min) in vollentsalztem Wasser redispergiert. Dieser Vorgang wurde zweimal wiederholt. Ein kolloidal-stabiles Sol mit einem Feststoffgehalt von 5 Gew.-% (Silberpartikel und Dispergierhilsmittel) wurde so erhalten. Die Ausbeute betrug knapp 100 %. Die Silberdispersion enthielt nach der Zentrifugation laut Elementaranalyse 3 Gew.-% Disperbyk 190 bezogen auf den Silbergehalt. Eine Untersuchung mittels Laserkorrelationsspektroskopie ergab einen effektiven Durchmesser der Partikel von 73 nm.

### Beispiel 2

### Herstellung der Silberpartikel mit Aufreinigung durch Membranfiltration

Es wurden eine 0,054 molare Silbernitratlösung mit einer Mischung aus einer 0,054 molaren Natronlauge und dem Dispergierhilfsmittel Disperbyk 190 (Hersteller BYK Chemie) (1 g/l) in einem Volumenverhältnis von 1:1 versetzt und 10 min gerührt. Zu dieser Reaktionsmischung wurde unter Rühren eine wässrige 4,6 molare wässrige Formaldehyd-Lösung zugesetzt, so dass das Verhältnis Ag⁺ zu Reduktionsmittel 1:10 beträgt. Diese Mischung wurde auf 60°C erwärmt, 30 min bei dieser Temperatur gehalten und anschließend abgekühlt. Die Partikel wurden in einem ersten Schritt mittels Diafitration von den nicht umgesetzten Edukten getrennt und anschließend wurde das Sol aufkonzentiert, dazu wurde eine Membran mit 30000 Dalton benutzt. Es entstand ein kolloidstabiles Sol mit einem Feststoffgehalt von 10 Gew.-% (Silberpartikel und Dispergierhilfsmittel). Der Anteil an Disperbyk 190 betrug laut Elementaranalyse nach der Membranfiltration 6 Gew.-% bezogen auf den Silbergehalt. Eine Untersuchung mittels Laserkorrelationsspektroskopie ergab einen effektiven Partikeldurchmesser von 78 nm.

### Beispiel 3

### Formulierung eine Silbertinte

1 ml eines 8 Gew.-% Silbersol aus Beispiel 2 wurde mit 1 ml einer Mischung aus 99 Gew.- Teilen Wasser, 1 Gew.- Teil Dioxalan, 0.03 Gew.- Teilen PVP K15 und 0.17 Gew.- Teilen Disperbyk 190 versetzt und gut verrührt. Ein Tropfen dieser Mischung wurde auf PC aufgegeben und bei 140°C 1 h gesintert. Der relative elektrische Widerstand des Tropfens betrug 0,1 Ohm.

### Beispiel 4

### Formulierung einer Silbertinte

1 ml eines 8 Gew.-% Silbersol aus Beispiel 2 wurde mit 1 ml einer Mischung aus 92 Gew.- Teilen Wasser und 8 Gew.- Teilen Ethanol, 0,01 Gew.- Teilen PVP K15 und 0,15 Gew.- Teilen PVP K90 versetzt und gut verrührt. Ein Tropfen dieser Mischung wurde auf PC aufgegeben und bei 140°C 1 h wärmebehandelt. Der realtive elektrische Widerstand des Tropfens betrug 0,1 Ohm.

### Beispiel 5

### Formulierung einer Silbertinte

1 ml eines 8 Gew.-% Silbersol aus Beispiel 2 werden mit 1 ml einer Mischung aus 90 Gew.-Teilen Wasser und 10 Gew.- Teilen Ethanol, 0,6 Gew.- Teilen PVP K15 und 0,3 Gew.- Teilen Pluronic PE 10400 versetzt und gut verrührt. Die erhaltene Tinte eignet sich besonders gut zum Drucken durch einen Piezo-Tintenstrahdrucker auf Polycarbonat. Die erhaltenen Linie wird unter Luft für 17 Stunden auf 140°C gehalten. Die daraufhin gemessene spezifische Leitfähigkeit erreicht mit 7·10⁶ S/m gut zehn Prozent der elektrischen Leitfähigkeit von metallischem Silber.

### Beispiel 6

### Formulierung einer Silbertinte (EID 1034 V 14)

1 ml eines 8 Gew.-% Silbersol aus Beispiel 2 werden mit 1 ml einer Mischung aus 99 Gew.-Teilen Wasser und 1 Gew.- Teilen Ethanol, 0,01 Gew.- Teilen PVP K90 und 0,04 Gew.- Teilen Pluronic PE 10400 sowie 0,02 Gew.- Teilen BYK 356 versetzt und gut verrührt. Ein Tropfen dieser Mischung wird auf PC aufgegeben und bei 140°C 1 h gesintert. Die erhaltene Tinte eignet sich besonders gut zum Hinterspritzen mit Polycarbonat.

### Beispiel 7

### Formulierung einer Silbertinte

8,5 ml eines 18,5 Gew.-% Silbersols aus Beispiel 2 werden mit 1,5 ml reinem Ethanol versetzt. Hierzu werden 0,05 g Polyvinylpyrrolidon K15, zusammen mit 0,04 g Pluronic PE 10400 und 0,03 g BYK348 eingewogen. Die resultierende Formulierung wird gut durchmischt, so dass eine homogene braun-gräuliche Dispersion entsteht. Die erhaltene Tinte eignet sich besonders gut für die Erzeugung visuell, d.h. mit dem bloßen Auge schwer oder nicht erkennbarer Linien auf vorstrukturiertem Polycarbonat. Die Tinte wird in die Strukturen auf Polycarbonat eingefüllt und 17h bei 140°C getrocknet. Der relative elektrische Widerstand eines ebenfalls aus der Tinte hergestellten Tropfens betrug 0,1 Ohm. Die Oberflächenspannung der Formulierung betrug 22 mN/m.

### Ergebnisse

### Haftfestigkeit

Zur Prüfung der Haftfestigkeit wurden Polycarbonatfolien durch "Fluten" mit der zu prüfenden Silberdispersion - nachstehend auch kurz Tinte genannt - beschichtet, also durch Schrägstellen der Folie und herunter laufen lassen der Tinte aus Beispiel 1 bis 6 über die unbehandelte Polycarbonatfolie. Anschließend wurden die Folien getrocknet und bei ca. 140 °C in Luft 17 Stunden lang gelagert. Die erhaltene Beschichtungsdicke lag bei etwa 1 µm (im Falle der Tinte aus Beispiel 1) und bei etwa 6 µm bei der kommerziell erhältlichen Vergleichstinte (Cabot Inkjet Silver Conductor AG-IJ-G-100-S1). Die höhere Schichtdicke der Vergleichstinte resultiert aus deren höherem Feststoffgehalt.

Der Vergleich der Haftfestigkeit der Silberschicht aus der erfindungsgemäßen Tinte nach Beispiel 1 zur Silberschicht aus der kommerziell erhältlichen Tinte erfolgte auf zwei Wegen: Zum einen wurde ein so genannter Gitterschnitttest durchgeführt: Mit einem Messer wurden beide Beschichtungen mehrfach parallel und dann senkrecht bis auf das Substrat eingeritzt. Anschließend wurde ein Klebestreifen auf die angeritzten Stellen gedrückt und wieder abgezogen. Das Bild, das sich nach dem Abziehen des Klebestreifens ergibt, zeigt ein rein qualitatives Ergebnis bezüglich der Haftfestigkeit der Beschichtung auf der Polycarbonatfolie. Hier zeigt die mit einer Tinte nach Beispiel 1 beschichtete Folie überraschend, dass die Haftung der Silberschicht wesentlich besser ist (Fig. 1) als die Haftung der Silberschicht aus der Tinte nach Stand der Technik (Fig. 2).

Als weitere Methode zum Vergleich der Haftfestigkeiten der Silberschicht aus der Tinte nach Beispiel 1 und der Silberschicht aus dem Stand der Technik wurden auf die mit der Tinte lackierten Fläche kleine Metallstempel aufgeklebt. Auf die Metallstempel wurde eine Drehung mit 3° pro Minute ausgeübt und das benötigte Drehmoment gemessen, bis sich der Stempel wieder von der Unterlage abgelöst hat.

Dabei konnten grundsätzlich zwei verschiedene Arten des Bruches unterschieden werden: Der Adhäsionsbruch, bei dem es zu einem Ablösen der Tinte vom Substrat gekommen ist, und dem Kohäsionsbruch, bei dem der Bruch innerhalb der Silberschicht erfolgte, da die Haftung zwischen Substrat und Silberschicht größer ist als die Kräfte, die innerhalb der Silberschicht wirken. Ein Kohäsionsbruch ist grundsätzlich ein Zeichen für eine gute Haftung zwischen der Silberschicht und dem Substrat.

Von beiden Silberschichten wurden jeweils sechs Proben mit Tinten nach Beispiel 1 auf die oben beschriebene Art und Weise vermessen. Der Mittelwert der Messungen zeigt, dass es bei der Silberschicht der Tinte aus dem Stand der Technik zu einem Adhäsionsbruch kommt, der im arithmetischen Mittel bereits bei 1,26 Nm auftritt, bei der Silberschicht aus der Tinte nach Beispiel 1 aber zu einem Kohäsionsbruch kommt, der im arithmetischen Mittel bei 4,24 Nm auftritt.

Die Schichtdicken betrugen im vorliegenden Fall etwa 6 µm für die Tinte nach Stand der Technik und etwa 1 µm für die Tinte nach Beispiel 1.

### Spezifische elektrische Leitfähigkeit

Weil die Verwendung von Polycarbonat als Substrat für eine leitfähige Beschichtung die Nachbehandlungstemperatur zur Ausbildung einer elektrisch leitfähigen Struktur auf etwa 140 °C beschränkt, können solche Nachbehandlungen entsprechend nur bei niedrigen Temperaturen bis max. 140 °C durchgeführt werden. Eine möglichst hohe elektrische Leitfähigkeit der aufgedruckten Strukturen durch möglichst niedrige Nachbehandlungstemperatur ist für die meisten handelsüblichen Polymere von großer Wichtigkeit.

An einer mit einem InkJet-Drucker auf Polycarbonat aufgedruckten, etwa 4 cm langen Line der Tinte nach Beispiel 1-5 wurde nach einer 17 stündigen Nachbehandlung bei etwa 140°C die spezifische elektrische Leitfähigkeit gemessen. Hierzu wurde der Leitungsquerschnitt der Linie mit Hilfe eines Weißlichttopographiemikroskopes bestimmt, vier Kontakte mit Silberleitkleber im Abstand von 1 cm, 2 cm und 1 cm angebracht und die Leitfähigkeit der Linie durch eine Vierpunktmessung über eine Länge von 2 cm bestimmt.

Mit Hilfe der Daten aus der Querschnittsfläche ergab sich hieraus eine spezifische Leitfähigkeit für eine Tinte nach Beispiel 5 von **7*10⁶ S/m** (etwa 10% der Leitfähigkeit von kompaktem Silber), die ebenfalls über dem Wert der Vergleichstinte der Fa. Cabot von etwa **4*10⁶ S/m,** ebenfalls nach Vorbehandlung bei etwa 140 °C steht.

### Hinterspritzbarkeit

Eine Polycarbonat-Folie (Makrofol) wird mit Tinte aus Beispiel 6 betropft. Die erhaltenen Tropfen trocknen bei Raumtemperatur ein, und die eingetrocknete Tinte wird 17 Stunden unter Luft bei 140°C gehalten.

Der so erhaltene, silbrig glänzende Tropfen wird in ein Hinterspritzwerkzeug eingelegt und mit flüssigem Polycarbonat überspritzt.

Das erhaltene Muster zeigt, dass sich die Form der silbrig glänzenden Tropfen unter dem Einfluß des beim Hinterspritzen herrschenden hohen Druckes und der hohen Temperaturen optisch nicht verändert, so daß die in Beispiel 6 beschriebene Tinte auch für den Einsatz im Hinterspritzprozess geeignet ist.

## Patentansprüche

1. Silberhaltige, disperse, Wasser enthaltende Formulierung wenigstens umfassend
a) von 0,5 bis 30 Gew.-Teile Silbermetallpartikel mit einem effektiven Durchmesser von höchstens 150 nm mit bimodaler Größenverteilung der Silbermetallpartikel, ermittelt mit der Laserkorrelationsspektrokopie,
b) von 50 bis 99,5 Gew.-Teile Wasser und gegebenenfalls bis zu 30 Gew.-Teile Lösungsmittel,
c) von 0,01 bis 10 Gew.-Teile wenigstens eines Dispergierhilfsmittels,
d) von 0 bis 5 Gew.- Teile Filmbildner,
e) von 0 bis 5 Gew.- Teile Additive,
f) von 0 bis 5 Gew.-Teile leitfähige Polymere,
**dadurch gekennzeichnet, dass** die Formulierung eine Viskosität von höchstens 150 mPa·s aufweist.

2. Formulierung nach Anspruch 1, **dadurch gekennzeichnet, dass** das Dispergierhilfsmittel ein polymeres Dispergierhilfsmittel ist.

3. Formulierung nach Anspruch 1 oder 2, **dadurch gekennzeichnet, dass** das Dispergierhilfsmittel wenigstens ein Mittel ausgewählt aus der Gruppe: Alkoxylate, Alkylolamide, Ester, Aminoxide, Alkylpolyglukoside, Alkylphenole, Arylalkylphenole, wasserlösliche Homopolymere, wasserlösliche statistische Copolymere, wasserlösliche Blockcopolymere, wasserlösliche Pfropfpolymere, Polyvinylalkohole, Copolymere aus Polyvinylalkoholen und Polyvinylacetaten, Polyvinylpyrrolidone, Cellulose, Stärke, Gelatine, Gelatinederivate, Aminosäurepolymere, Polylysin, Polyasparaginsäure, Polyacrylate, Polyethylensulfonate, Polystyrolsulfonate, Polymethacrylate, Kondensationsprodukte von aromatischen Sulfonsäuren mit Formaldehyd, Naphthalinsulfonate, Ligninsulfonate, Copolymerisate acrylischer Monomere, Polyethylenimine, Polyvinylamine, Polyallylamine, Poly(2-vinylpyridine), Block-Copolyether, Block-Copolyether mit Polystyrolblöcken und/oder Polydiallyldimethylammoniumchlorid ist.

4. Formulierung nach Anspruch 1 oder 3, **dadurch gekennzeichnet, dass** das Dispergierhilfsmittel ausgewählt ist aus der Reihe: Block-Copolyether und Block-Copolyether mit Polystyrolblöcken.

5. Formulierung nach einem der Ansprüche 1 bis 4, **dadurch gekennzeichnet, dass** das Lösungsmittel b) ausgewählt ist aus der Reihe: C₁- bis C₅- Alkohol, Ether, Ketone.

6. Formulierung nach einem der Ansprüche 1 bis 5, **dadurch gekennzeichnet, dass** der Filmbildner d) ausgewählt ist aus der Reihe: Polydimethylsiloxan, Polyacrylat, Ammoniumsalze von Polyacrylaten, Siloxane, Wachskombinationen, Copolymere mit pigmentaktiven Gruppen, niedermolekulare Polymere, Hydroxyethylcellulose und Polyvinylalkohol.

7. Formulierung nach einem der Ansprüche 1 bis 6, **dadurch gekennzeichnet, dass** das leitfähige Polymer f) ausgewählt ist aus der Reihe: Polypyrrol, Polyanilin, Polythiophen, Polyphenylenvinylen, Polyparaphenylen, Polyethylendioxythiophen, Polyfluoren, Polyacetylen, Polyethylendioxythiophen/Polystyrolsulfonsäure.

8. Formulierung nach einem der Ansprüche 1 bis 7, **dadurch gekennzeichnet, dass** die Silberpartikel a) einen effektiven Partikeldurchmesser von 10 bis 150 nm aufweisen, ermittelt mit der Laserkorrelationsspektrokopie.

9. Formulierung nach einem der Ansprüche 1 bis 8, **dadurch gekennzeichnet, dass** die Silberpartikel a) zu einem Anteil von 1 bis 20 Gew.-Teilen enthalten sind.

10. Formulierung nach einem der Ansprühe 1 bis 9, **dadurch gekennzeichnet, dass** der Gehalt an Dispergierhilfsmittel c) 0,02 bis 5 Gew.-Teile beträgt.

11. Formulierung nach einem der Ansprüche 1 bis 10, **dadurch gekennzeichnet, dass** die dispergierten Silberpartikel einer Membranfiltration mit einer Filterfeinheit von höchstens 100.000 Da unterzogen sind.

12. Verwendung der Formulierung nach einem der Ansprüche 1 bis 11 zur Erzeugung von elektrisch leitenden und/oder optisch spiegelnden Beschichtungen, insbesondere von Leiterbahnen einer Linienbreite von kleiner als 100 µm.

13. Verwendung gemäß Anspruch 12 mittels einem Verfahren zur Erzeugung von Leiterbahnen einer Linienbreite von kleiner als 100 µm, **dadurch gekennzeichnet, dass** die Formulierung mit Hilfe der Tintenstrahltechnik auf eine Substratoberfläche gedruckt und zur Entfernung von Wasser und gegebenenfalls Lösungsmittel wärmebehandelt wird.

14. Verwendung gemäß Anspruch 12 oder 13, **dadurch gekennzeichnet, dass** bei einer Temperatur von höchstens 140°C zur Entfernung von Wasser und gegebenenfalls Lösungsmittel wärmebehandelt wird.

15. Verwendung gemäß Anspruch 12 oder 13 mittels einem Verfahren zur Erzeugung von Leiterbahnen mit einer Linienbreite von kleiner 20 µm, **dadurch gekennzeichnet, dass** die Formulierung in die vorgegebene Strukturierung eines Substrates eingebracht wird, wobei die Strukturierung eine Linienbreite von < 20 µm aufweist, und die aufgebrachte Formulierung zur Entfernung von Wasser und gegebenenfalls Lösungsmittel wärmebehandelt wird.

16. Substrat, insbesondere transparentes Kunststoffsubstrat aufweisend eine elektrisch leitende und/oder optisch spiegelnde Beschichtung erhältlich aus einer Formulierung nach einem der Ansprüche 1 bis 11.

17. Substrat nach Anspruch 16, **dadurch gekennzeichnet, dass** die elektrisch leitende Beschichtung Leiterbahnen einer Linienbreite von kleiner als 100 µm umfasst, wobei die Leitfähigkeit in den Leiterbahnen mindestens 7·10⁻⁶ S/m beträgt.

## Claims

1. Silver-containing, disperse, water-containing formulation at least comprising
a) from 0.5 to 30 parts by weight of silver metal particles having an effective diameter of at most 150 nm with bimodal size distribution of the silver metal particles, determined by laser correlation spectroscopy,
b) from 50 to 99.5 parts by weight of water and optionally up to 30 parts by weight of solvent,
c) from 0.01 to 10 parts by weight of at least one dispersing assistant,
d) from 0 to 5 parts by weight of film former,
e) from 0 to 5 parts by weight of additives,
f) from 0 to 5 parts by weight of conductive polymers,
**characterized in that** the formulation has a viscosity of at most 150 mPa·s.

2. Formulation according to Claim 1, **characterized in that** the dispersing assistant is a polymeric dispersing assistant.

3. Formulation according to Claim 1 or 2, **characterized in that** the dispersing assistant is at least one agent selected from the following group: alkoxylates, alkylolamides, esters, amine oxides, alkylpolyglucosides, alkylphenols, arylalkylphenols, water-soluble homopolymers, water-soluble random copolymers, water-soluble block copolymers, water-soluble graft polymers, polyvinyl alcohols, copolymers of polyvinyl alcohols and polyvinyl acetates, polyvinylpyrrolidones, cellulose, starch, gelatin, gelatin derivatives, amino acid polymers, polylysine, polyaspartic acid, polyacrylates, polyethylenesulfonates, polystyrenesulfonates, polymethacrylates, condensation products of aromatic sulfonic acids with formaldehyde, naphthalenesulfonates, lignosulfonates, copolymers of acrylic monomers, polyethyleneimines, polyvinylamines, polyallylamines, poly(2-vinylpyridines), block copolyethers, block copolyethers with polystyrene blocks and/or polydiallyldimethylammonium chloride.

4. Formulation according to Claim 1 or 3, **characterized in that** the dispersing assistant is selected from the following series: block copolyethers and block copolyethers with polystyrene blocks.

5. Formulation according to any of Claims 1 to 4, **characterized in that** the solvent b) is selected from the following series: C₁ to C₅ alcohol, ethers, ketones.

6. Formulation according to any of Claims 1 to 5, **characterized in that** the film former d) is selected from the following series: polydimethylsiloxane, polyacrylate, ammonium salts of polyacrylates, siloxanes, wax combinations, copolymers with pigment-active groups, low molecular mass polymers, hydroxyethylcellulose and polyvinyl alcohol.

7. Formulation according to any of Claims 1 to 6, **characterized in that** the conductive polymer f) is selected from the following series: polypyrrole, polyaniline, polythiophene, polyphenylenevinylene, polyparaphenylene, polyethylenedioxythiophene, polyfluorene, polyacetylene, polyethylenedioxythiophene/polystyrenesulfonic acid.

8. Formulation according to any of Claims 1 to 7, **characterized in that** the silver particles a) have an effective particle diameter of 10 to 150 nm, determined by laser correlation spectroscopy.

9. Formulation according to any of Claims 1 to 8, **characterized in that** the silver particles a) are included in a fraction of 1 to 20 parts by weight.

10. Formulation according to any of Claims 1 to 9, **characterized in that** the amount of dispersing assistant c) is 0.02 to 5 parts by weight.

11. Formulation according to any of Claims 1 to 10, **characterized in that** the dispersed silver particles have been subjected to a membrane filtration with a filter fineness of at most 100 000 Da.

12. Use of the formulation according to any of Claims 1 to 11 for producing electrically conducting and/or optically reflecting coatings, more particularly conductor tracks with a line width of less than 100 *µ*m.

13. Use according to Claim 12 by means of a method for producing conductor tracks with a line width of less than 100 *µ*m, **characterized in that** the formulation is printed by means of the inkjet technology onto a substrate surface and is heat-treated for removal of water and optionally solvent.

14. Use according to Claim 12 or 13, **characterized in that** heat-treatment takes place at a temperature of at most 140°C for removing water and optionally solvent.

15. Use according to Claim 12 or 13 by means of a method for producing conductor tracks with a line width of less than 20 *µ*m, **characterized in that** the formulation is introduced into the existing patterning of a substrate, the patterning having a line width of < 20 *µ*m, and the formulation applied is heat-treated for removal of water and optionally solvent.

16. Substrate, more particularly transparent plastics substrate, having an electrically conducting and/or optically reflecting coating obtainable from a formulation according to any of Claims 1 to 11.

17. Substrate according to Claim 16, **characterized in that** the electrically conducting coating comprises conductor tracks with a line width of less than 100 *µ*m, the conductivity in the conductor tracks being at least 7·10⁻⁶ S/m.

## Revendications

1. Composition contenant de l'eau, dispersée, contenant de l'argent, comprenant au moins
a) de 0,5 à 30 parties en poids de particules d'argent métallique ayant un diamètre effectif d'au maximum 150 nm, à distribution bimodale de tailles des particules d'argent métallique, déterminée à l'aide de la spectroscopie de corrélation laser,
b) de 50 à 99,5 parties en poids d'eau et éventuellement jusqu'à 30 parties en poids de solvant,
c) de 0,01 à 10 parties en poids d'au moins un adjuvant de dispersion,
d) de 0 à 5 parties en poids d'agent filmogène,
e) de 0 à 5 parties en poids d'additifs,
f) de 0 à 5 parties en poids de polymères conducteurs,
**caractérisée en ce que** la composition présente une viscosité d'au maximum 150 mPa.s.

2. Composition selon la revendication 1, **caractérisée en ce que** l'adjuvant de dispersion est in adjuvant de dispersion polymère.

3. Composition selon la revendication 1 ou 2, **caractérisée en ce que** l'adjuvant de dispersion est au moins un agent choisi dans le groupe constitué par : des alcoxylates, alkylolamides, esters, oxydes d'amines, alkylpolyglucosides, alkylphénols, arylalkylphénols, homopolymères hydrosolubles, copolymères statistiques hydrosolubles, copolymères séquencés hydrosolubles, polymères greffés hydrosolubles, poly(alcool vinylique)s, copolymères de poly(alcool vinylique)s et poly(acétate de vinyle)s, la polyvinylpyrrolidone, la cellulose, l'amidon, la gélatine, des dérivés de la gélatine, des polymères d'acides aminés, la polylysine, le poly(acide aspartique), des polyacrylates, polyéthylènesulfonates, polystyrènesulfonates, polyméthacrylates, des produits de condensation d'acides sulfoniques aromatiques avec le formaldéhyde, des naphtalènesulfonates, lignine-sulfonates, des copolymérisats de monomères acryliques, des polyéthylène-imines, polyvinylamines, polyallylamines, poly(2-vinylpyridine)s, des copolyéthers séquencés, des copolyéthers séquencés à séquences polystyrène et/ou le poly(chlorure de diallyl-diméthylammonium).

4. Composition selon la revendication 1 ou 3, **caractérisée en ce que** l'adjuvant de dispersion est choisi dans la série : copolyéthers séquencés et copolyéthers séquencés à séquences polystyrène.

5. Composition selon l'une quelconque des revendications 1 à 4, **caractérisée en ce que** le solvant b) est choisi dans la série : alcool en C₁-C₅, éthers, cétones.

6. Composition selon l'une quelconque des revendications 1 à 5, **caractérisée en ce que** l'agent filmogène d) est choisi dans la série : polydiméthylsiloxane, polyacrylate, sels d'ammonium de polyacrylates, siloxanes, associations de cires, copolymères comportant des groupes à activité pigmentaire, polymères de faible masse moléculaire, hydroxyéthylcellulose et poly(alcool vinylique).

7. Composition selon l'une quelconque des revendications 1 à 6, **caractérisée en ce que** le polymère conducteur f) est choisi dans la série : polypyrrole, polyaniline, polythiophène, polyphénylène-vinylène, polyparaphénylène, polyéthylène-dioxythiophène, polyfluorène, polyacétylène, polyéthylènedioxythiophène/poly(acide styrène-sulfonique).

8. Composition selon l'une quelconque des revendications 1 à 7, **caractérisée en ce que** les particules d'argent a) présentent un diamètre de particule effectif de 10 à 150 nm, déterminé à l'aide de la spectroscopie de corrélation laser.

9. Composition selon l'une quelconque des revendications 1 à 8, **caractérisée en ce que** les particules d'argent a) sont contenues en une proportion de 1 à 20 parties en poids.

10. Composition selon l'une quelconque des revendications 1 à 9, **caractérisée en ce que** la teneur en adjuvant de dispersion c) vaut de 0,02 à 5 parties en poids.

11. Composition selon l'une quelconque des revendications 1 à 10, **caractérisée en ce que** les particules d'argent dispersées sont soumises à une filtration sur membrane avec une finesse de filtration d'au maximum 100 000 Da.

12. Utilisation de la composition selon l'une quelconque des revendications 1 à 11, pour la production de revêtements conducteurs de l'électricité et/ou optiquement réfléchissants, en particulier de pistes conductrices ayant une largeur de piste de moins de 100 *µ*m.

13. Utilisation selon la revendication 12 au moyen d'un procédé pour la production de pistes conductrices ayant une largeur de piste de moins de 100 *µ*m ; **caractérisée en ce qu'**on imprime la composition sur une surface de substrat à l'aide de la technique de jet d'encre et pour l'élimination de l'eau et éventuellement de solvant on la traite thermiquement.

14. Utilisation selon la revendication 12 ou 13, **caractérisée en ce que** pour l'élimination de l'eau et éventuellement de solvant on traite thermiquement à une température d'au maximum 140 °C.

15. Utilisation selon la revendication 12 ou 13 au moyen d'un procédé pour la production de pistes conductrices ayant une largeur de piste de moins de 20 *µ*m ; **caractérisée en ce qu'**on introduit la composition dans la structuration préalablement réalisée d'un substrat, la structuration présentant une largeur de piste de < 20 µm, et pour l'élimination de l'eau et éventuellement de solvant on traite thermiquement la composition appliquée.

16. Substrat, en particulier substrat transparent en matière plastique, comportant un revêtement conducteur de l'électricité et/ou optiquement réfléchissant, pouvant être obtenu à partir d'une composition selon l'une quelconque des revendications 1 à 11.

17. Substrat selon la revendication 16, **caractérisé en ce que** le revêtement conducteur de l'électricité comprend des pistes conductrices ayant une largeur de piste de moins de 100 *µ*m, la conductivité dans les pistes conductrices étant d'au moins 7.10⁻⁶ S/m.
